# DEMANDE DE BREVET EUROPEEN

(11) **EP 4 746 631 A1**
(43) Date de publication de la demande: **20.05.2026**
(21) Numéro de dépôt: 25214736.8
(22) Date de dépôt: 10.11.2025
(51) Int. Cl.: H10D 48/01, H10D 48/00, H10D 64/27, H10D 62/10, B82Y 10/00

(54) **DISPOSITIF QUANTIQUE AVEC DES BOÎTES QUANTIQUES DÉFINIES PAR DES GRILLES ET PAR DES PARTIES AMINCIES DE LA COUCHE ACTIVE ET PROCÉDÉ DE FABRICATION DE CELUI-CI**

(30) Priorité: 13.11.2024 FR 2412389
(71) Demandeur: Commissariat à l'Energie Atomique et aux Energies Alternatives, 75015 Paris (FR)
(72) Inventeur: SAHIN, HAMZA, 38054 Grenoble Cedex 09 (FR); MARTINEZ I DIAZ, BIEL, 38054 Grenoble Cedex 09 (FR); BERTRAND, BENOIT, 38054 Grenoble Cedex 09 (FR)
(74) Mandataire: Hautier IP

(57) **Abrégé**

L'invention concerne un dispositif quantique (1) comprenant en empilement suivant une direction z, une couche de support (5), une couche active (10) à base d'un matériau semi-conducteur surmontant la couche de support et présentant une épaisseur, une couche diélectrique (15) surmontant la couche active et un réseau de premières grilles (20) surmontant la couche diélectrique, les premières grilles adjacentes du réseau étant séparées entre elles par des espaces, dits inter-grilles, remplies de deuxièmes grilles (40). Dans le dispositif (1) la couche active (10) comprend, en dessous des espaces inter-grilles, des zones amincies (11) à base du matériau semi-conducteur.

## Description

### DOMAINE TECHNIQUE

La présente invention concerne le domaine technique de l'information quantique. Elle trouve par exemple pour application particulièrement avantageuse le codage de l'information sur le spin de « bits quantiques » ou « Qubits ».

### ETAT DE LA TECHNIQUE

Les boîtes quantiques forment des éléments de base d'un dispositif électronique quantique. Les boîtes quantiques sont typiquement formées dans une couche active de matériau semi-conducteur alternée avec des couches d'autres matériaux, suivant au moins une direction de l'espace. Dans cette couche active, des puits de potentiel sont mis en oeuvre pour confiner des porteurs, électrons ou trous, dans les trois dimensions de l'espace. Une information quantique peut être alors codée par le biais du spin du porteur. On parle alors de Qubits de spin.

Selon une approche, des électrons sont confinés par effet de champ sous l'effet d'électrodes de grilles semblables à celles utilisées dans des structures de transistors et l'information est encodée dans le spin de ces électrons. Ces grilles de contrôle sont disposées au-dessus de l'ensemble des boîtes quantiques.

Le confinement électrostatique est souvent insuffisant pour garantir un bon positionnement des boîtes quantiques sous la grille, créant ainsi un désordre de charges. Ce désordre de charges rend difficile la définition, d'une façon reproductible, de la position d'une boîte quantique via l'ajustement des potentiels électriques appliqués sur les grilles.

Une solution pour limiter ce désordre de charges, consiste à gérer le piégeage de charges aux interfaces entre la couche active et les autres couches. Une autre solution divulguée dans le document FR3143798 consiste à compléter le confinement électrostatique des charges par un confinement structurel latéral en formant des ouvertures dans la couche active entre les grilles, sur toute l'épaisseur de la couche active. Cela limite cependant le couplage tunnel entre les qubits.

Un objet de la présente invention est de proposer une solution alternative qui vise à améliorer le positionnement des boîtes quantiques sous la grille. Un autre objet de la présente invention, est d'optimiser le couplage tunnel entre les boîtes quantiques.

### RESUME

Pour atteindre cet objectif, selon un mode de réalisation on prévoit un dispositif quantique comprenant en empilement suivant une direction z :
- une couche de support,
- une couche active à base d'un matériau semi-conducteur surmontant la couche de support et présentant une épaisseur e10,

- une couche diélectrique surmontant la couche active,
- un réseau de premières grilles surmontant la couche diélectrique, les premières grilles adjacentes du réseau étant séparées entre elles par des espaces dits inter-grilles,

Avantageusement, la couche active comprend, en dessous des espaces inter-grilles, des zones amincies à base du matériau semi-conducteur, lesdites zones amincies présentant chacune au moins une épaisseur e11 > 0 telle que e11 < e10.

Ce dispositif quantique permet ainsi d'améliorer le confinement structurel de boites quantiques au sein de la couche active. Le confinement vertical, selon la direction z, est plus élevé au niveau des zones amincies. Cela limite la mobilité des boites quantiques au sein de la couche active. Ce confinement structurel vient donc renforcer le contrôle de la position des boites quantiques. Cela rend plus favorable le positionnement des boîtes quantiques sous les premières grilles. Ce confinement structurel des boîtes quantiques, orthogonal au plan de la couche active et désigné confinement vertical dans la suite, permet notamment d'améliorer la précision et l'homogénéité du positionnement des boîtes quantiques. Cela réduit significativement l'impact du désordre de charges sur les qubits. Grâce au confinement vertical, la probabilité de fusion des boîtes quantiques est significativement diminuée. Par ailleurs, l'épaisseur non nulle des zones amincies permet avantageusement de conserver un couplage tunnel satisfaisant entre deux boîtes quantiques voisines.

L'invention prévoit également selon un deuxième aspect un procédé de fabrication d'un tel dispositif quantique. Ce procédé comprend :
- une fourniture d'une couche de support et d'une couche active à base d'un matériau semi-conducteur surmontant la couche de support, ladite couche active présentant une épaisseur e10,
- une formation d'une couche diélectrique surmontant la couche active,
- une formation, sur la couche diélectrique, d'un réseau de premières grilles, les premières grilles adjacentes du réseau étant séparées entre elles par des espaces dits inter-grilles,
- un amincissement uniquement partiel de la couche active, selon la direction z à l'aplomb des espaces inter-grilles, de façon à former dans la couche active les zones amincies.

Les avantages décrits ci-dessus en regard du dispositif s'appliquent *mutatis mutandis* au procédé selon l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1G illustrent dans un plan xz, des coupes transversales représentant différentes étapes du procédé de fabrication d'un dispositif quantique selon un exemple de réalisation.
Les figures 2A à 2J illustrent schématiquement dans un plan xz, des coupes transversales représentant différentes étapes du procédé de fabrication d'un dispositif quantique selon un autre exemple de réalisation.
Les figures 3A à 3H illustrent schématiquement dans un plan xz, des coupes transversales représentant différentes étapes du procédé de fabrication d'un dispositif quantique selon un autre exemple de réalisation.
La figure 4 illustre schématiquement en vue de dessus un dispositif quantique final selon un exemple de réalisation.
La figure 5 illustre schématiquement dans un plan xz, une coupe transversale d'un dispositif quantique final selon un exemple de réalisation.
Les figures 6A à 6C illustrent des résultats de simulation de la position de boîtes quantiques voisines dans un dispositif quantique selon la présente invention.
Les figures 7A à 7I illustrent schématiquement dans un plan xz, des coupes transversales représentant différentes étapes du procédé de fabrication d'un dispositif quantique selon un autre exemple de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches, motifs et reliefs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'au moins une épaisseur e11 des zones amincies est telle que e11 ≤ 0,8*e10. Le contrôle de l'épaisseur des zones amincies permet à la fois d'ajuster le confinement structurel des boites quantiques, et d'optimiser le couplage tunnel entre les boîtes quantiques voisines.

Selon un exemple, la couche active est à base de silicium, et l'épaisseur e10 de la couche active est de l'ordre de 10 nm. L'épaisseur e11 des zones amincies est ici comprise entre 8 nm et 2 nm, de préférence de l'ordre de 6 nm. Lorsque l'épaisseur e11 des zones amincies est inférieure à 2 nm, le confinement structurel dans la zone amincie est fort et le couplage tunnel est diminué. Lorsque l'épaisseur e11 des zones amincies est supérieure à 8 nm, le confinement structurel est faible et le couplage tunnel est augmenté. Une fusion des boîtes quantiques peut éventuellement se produire plus facilement. Pour ce jeu de paramètres, le meilleur compromis entre un couplage tunnel satisfaisant et un confinement structurel satisfaisant est obtenu pour une épaisseur e11 autour de 6 nm, soit un retrait de matière de l'ordre de 4 nm. L'épaisseur résiduelle e11 est de préférence de l'ordre de 4 nm +/-2 nm pour empêcher la fusion de boites quantiques.

Selon un exemple, les espaces inter-grilles peuvent être compris entre 5 nm et 40 nm, typiquement pour des grilles ayant des largeurs de 5 nm à 40 nm respectivement.

Selon un exemple, une seule zone amincie est prévue sous chaque espace inter-grilles. Selon un exemple, la zone amincie se situe au milieu de l'espace inter-grilles. Selon un exemple, la zone amincie présente une épaisseur minimale qui est localisée au milieu de l'espace inter-grilles.

Selon un exemple, le dispositif quantique comprend en outre un réseau de deuxièmes grilles disposées dans les espaces inter-grilles en alternance avec les premières grilles, de sorte que chaque deuxième grille surmonte une zone amincie. Les premières grilles, ou grilles de premier niveau, permettent le contrôle électrostatique de la position des boîtes quantiques. Les deuxièmes grilles, ou grilles de deuxième niveau, qui sont disposées au-dessus des zones amincies, permettent de contrôler le couplage tunnel entre les boîtes quantiques voisines.

Selon un exemple, les deuxièmes grilles présentent une extrémité située sous un plan passant par une face supérieure de la couche active. Cela permet de rapprocher les deuxièmes grilles de la couche active, au niveau des zones amincies. Cela augmente davantage le contrôle du couplage tunnel.

Selon un exemple, le dispositif quantique comprend au moins une couche d'espaceur couvrant des flancs des premières grilles, ladite au moins une couche d'espaceur étant intercalée entre les deuxièmes grilles et les zones amincies. La couche d'espaceur permet notamment l'isolation entre les premières et deuxièmes grilles, ce qui améliore les performances du dispositif.

Selon un exemple, l'au moins une couche d'espaceur est directement au contact des zones amincies, et de préférence directement au contact des deuxièmes grilles. Lorsque la couche d'espaceur est en nitrure de silicium, il n'y a pas de couche d'oxyde entre la couche d'espaceur et la couche active.

Selon un exemple, le dispositif comprend au moins une couche additionnelle surmontant la couche active et directement au contact de la couche active. Selon un exemple, la couche additionnelle et le substrat sont à base de SiGe et la couche active est à base de Si ou de Ge, de sorte que le substrat, la couche active et la couche additionnelle forment une hétérostructure de type SiGe/Si/SiGe ou SiGe/Ge/SiGe.

Selon un exemple, une première partie des zones amincies présente une première épaisseur e111 < e10, et une deuxième partie des zones amincies présente une deuxième épaisseur e112 < e10. Les épaisseurs e111 et e112 sont différentes entre elles. Cela permet de moduler localement le confinement structurel dans la couche active.

Selon un exemple, les zones amincies de la première partie sont situées sous des espaces inter-grilles situés entre des premières grilles selon une première direction x. Selon un exemple, les zones amincies de la deuxième partie sont situées sous des espaces inter-grilles situés entre des premières grilles selon une deuxième direction y. Le confinement structurel n'est pas uniforme selon x et selon y.

Selon un exemple, l'amincissement est réalisé, après retrait sélectif de la couche diélectrique dans les espaces inter-grilles, par une oxydation locale et uniquement partielle suivant la direction z de la couche active. Le retrait sélectif de la couche diélectrique permet d'exposer la couche active à l'aplomb des espaces inter-grilles. Cela permet d'accéder plus facilement à la couche active. L'amincissement par oxydation permet de réduire localement l'épaisseur de la couche active à base du matériau semi-conducteur. Une zone amincie de la couche active, délimitée par une zone oxydée de la couche active, est ainsi formée.

Selon un exemple, lors de l'amincissement par oxydation, les flancs des premières grilles sont également oxydés. Cela ne gêne pas le fonctionnement des premières grilles, et permet de rajouter une couche d'isolation entre les premières et les deuxièmes grilles.

Selon un exemple, l'amincissement est réalisé, après retrait sélectif de la couche diélectrique dans les espaces inter-grilles, par une gravure uniquement partielle suivant la direction z de la couche active.

Selon un exemple, la gravure de la couche active est une gravure humide.

Selon un exemple, le procédé comprend en outre, avant amincissement de la couche active, un dépôt d'une première couche d'espaceur sur des flancs des premières grilles, de façon à protéger lesdits flancs lors de l'amincissement. Cette première couche d'espaceur forme typiquement un premier espaceur uniquement sur les flancs des premières grilles. Outre la protection des flancs de grilles lors de l'amincissement, ce premier espaceur permet également de contrôler la dimension latérale des zones amincies finales. Cela permet notamment d'éviter ou de limiter la formation d'un « bec d'oiseau » lorsque l'amincissement est fait par oxydation. En ajustant l'épaisseur de ce premier espaceur, la dimension en largeur de la zone amincie peut être réduite. Cela permet également d'ajuster la force de couplage tunnel entre les boîtes quantiques voisines.

Selon un exemple, le procédé comprend en outre, après amincissement de la couche active, un dépôt d'une deuxième couche d'espaceur sur des flancs des premières grilles et sur des parties exposées des zones amincies.

Selon un exemple, le procédé comprend en outre, après dépôt de la deuxième couche d'espaceur, une formation d'un réseau de deuxièmes grilles disposées dans les espaces inter-grilles, en alternance avec les premières grilles.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy. Dans la présente demande de brevet, les zones amincies sont typiquement obtenues par retrait de matière et forment un « recess » ou retrait dans la couche active. Ce « recess » n'est pas nécessairement plan et peut présenter une surface incurvée. Le pourtour ou les bords des zones amincies peuvent être plus épais. Lorsque l'on mesure l'épaisseur des zones amincies, la mesure est effectuée au point le plus bas de la surface incurvée. L'épaisseur des zones amincies correspond donc à l'épaisseur minimale mesurée.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente un exemple de mise en œuvre du procédé selon l'invention dans un contexte d'élaboration d'un dispositif 3D complexe. Le cadre de cette description n'est évidemment pas limitatif de l'invention.

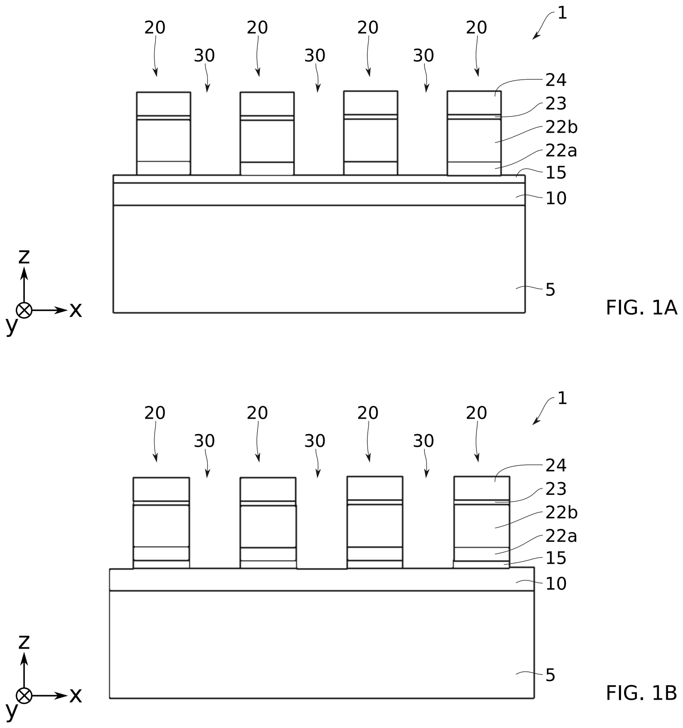

Les étapes de fabrication d'un dispositif quantique 100, en particulier un dispositif quantique à boîtes quantiques ou Qubits de spin, sont maintenant décrites. Les figures 1A à 1G décrivent le procédé de fabrication du dispositif 100 selon une première variante de l'invention.

Comme illustré à la figure 1A, le procédé comprend une fourniture d'une couche de support S présentant une face supérieure s'étendant dans un plan xy. La couche de support S est par exemple à base d'oxyde de silicium. La couche de support S est surmontée selon une direction z perpendiculaire aux directions x et y, par une couche active 10 à base d'un matériau semi-conducteur. La couche active 10 est par exemple une couche mince de silicium (topSi) s'étendant parallèlement au plan xy.

Plus généralement, la couche de support S et la couche active 10 peuvent correspondre en partie à un substrat de type SOI (Silicon On Insulator), GeOI (Germanium On Insulator) ou SGOI (Silicon-Germanium On Insulator). Ces substrats connus comprennent, selon la terminologie courante pour l'homme du métier, une couche de silicium épaisse dite « Si bulk » (non représentée sur les figures), une couche d'oxyde de silicium dite « BOX » (Burried Oxide) et une couche mince superficielle, respectivement à base de silicium, de germanium ou de silicium-germanium. La couche d'oxyde BOX peut correspondre à la couche de support S. La couche mince superficielle peut avantageusement correspondre à la couche active 10. La couche active 10 peut être de préférence à base de ²⁸Si lorsque cette couche est destinée à accueillir des Qubits de spin d'électrons.

La couche active 10 présente une épaisseur e10. L'épaisseur e10 peut être comprise entre 5 nm et 50 nm, de préférence de l'ordre de 10 nm. L'épaisseur de la couche support S, peut être de l'ordre de quelques centaines de nanomètres.

D'autres matériaux semi-conducteurs peuvent être envisagés pour la couche active 10. En particulier, lorsque cette couche active 10 est destinée à accueillir des qubits de spin de trous, elle peut être formée de Si₁₋ₓGeₓ avec x variant de préférence entre 0% à 70%.

Une première couche diélectrique 15 est ensuite formée sur la couche active 10, par dépôt ou par oxydation. Cette couche diélectrique 15 s'étend parallèlement au plan xy, et est superposée selon la direction z à la couche active 10 et la couche support S. Selon un exemple, le matériau de la première couche diélectrique 15 peut être à base de : SiO₂, HfO₂ ou Al₂O₃. La première couche diélectrique 15 peut être à base d'un matériau diélectrique à haute permittivité ou d'une combinaison de de matériaux diélectriques, par exemple SiO2 et HFO2.

Le procédé comprend en outre une étape de formation, sur la première couche diélectrique 15, d'un réseau de premières grilles 20. Cette étape comprend des sous-étapes non illustrées, qui sont bien connues de l'homme du métier. La formation des premières grilles 20 comprend le dépôt d'un empilement de grille comprenant : une première couche de grille 22a surmontant la première couche diélectrique 15, une deuxième couche de grille 22b surmontant la couche diélectrique de grille 22a, une couche de protection 23 surmontant la deuxième couche de grille 22b et un masque de gravure 24 dit masque dur, qui permet de structurer les premières grilles 20.

La première couche de grille 22a peut être à base de TiN. La deuxième couche de grille 22b peut être à base de silicium polycristallin. Selon une possibilité, les première et deuxième couches de grille 22a, 22b forment une seule et même couche à base d'un seul matériau, par exemple Si, TiN, ou un métal. La couche de protection 23 est typiquement à base d'oxyde de silicium. Le masque dur 24, qui reste en place après gravure de la grille, est typiquement à base de nitrure de silicium (SiN). Son rôle est de protéger le sommet des premières grilles 20 de tout dommage lors de la réalisation des étapes suivantes et notamment les étapes de gravure.

Le réseau de premières grilles 20 est ensuite formé par gravure de l'empilement de grille, avec arrêt sur la première couche diélectrique 15. Les premières grilles 20 ainsi obtenues sont séparées les unes des autres par des espaces 30 dits espaces « inter-grilles ». Ace stade, les flancs des premières grilles 20 et la première couche diélectrique 15 sont exposés au sein des espaces 30 inter-grilles.

Après formation du réseau des premières grilles 20, le procédé comprend un amincissement uniquement partiel de la couche active 10 selon la direction z. Cet amincissement est seulement réalisé à l'aplomb des espaces 30 inter-grilles, pour former des zones amincies 11. L'amincissement peut être mis en œuvre selon différentes variantes qui sont décrites ci-dessous. Les figures 1B à 1G illustrent les différentes étapes du procédé selon une première variante de la présente invention.

Comme illustré à la figure 1B, selon la première variante, le procédé comprend, suite à la formation des premières grilles 20, une étape de retrait sélectif de la couche diélectrique 15 dans les espaces 30 inter-grilles. Ce retrait permet de retirer sélectivement le matériau de la première couche diélectrique 15 vis-à-vis des matériaux des premières grilles 20 et de la couche active 10. Ce retrait permet d'exposer des parties de la surface de la couche active 10 situées à l'aplomb des espaces 30 inter-grilles. Cela permet un accès direct à la couche active 10 lors de l'étape d'amincissement. L'épaisseur de la couche active 10 dans ces parties exposées, est très peu, voire non impactée, par les étapes du procédé décrites ci-dessus. C'est grâce à l'étape d'amincissement que cette épaisseur est modifiée d'une manière contrôlée et ponctuelle.

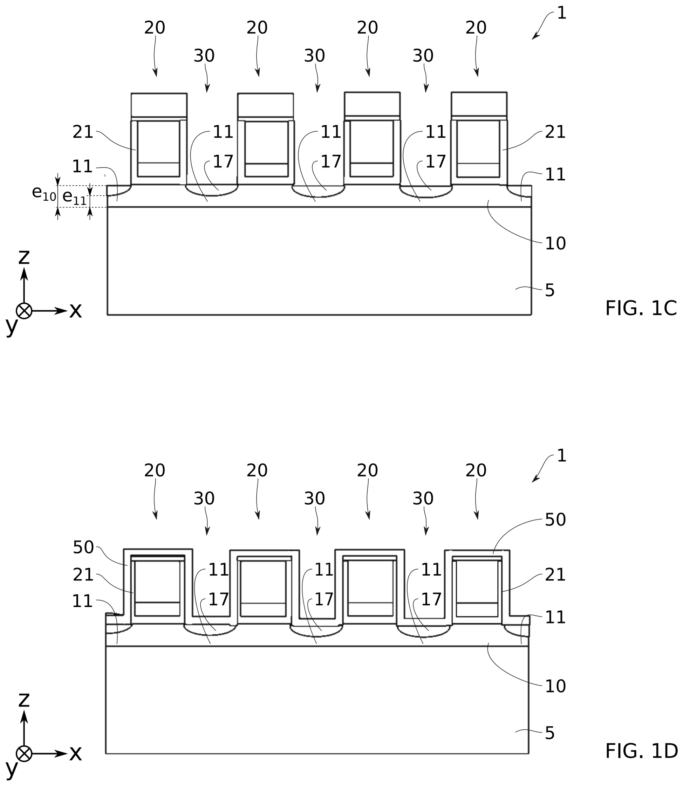

Comme illustré à la figure 1C, selon la première variante, l'amincissement est réalisé par une oxydation locale en introduisant à travers les espaces 30 inter-grilles, un agent oxydant qui interagit avec le matériau de la couche active 10 pour former des premières régions oxydées 17 dans la couche active 10. Ces premières régions oxydées 17 s'étendent latéralement suivant les directions x et y en dessous des espaces 30 inter-grilles, et verticalement suivant la direction z, sans atteindre la couche de support S. Ces premières régions oxydées 17 délimitent des zones amincies 11 dans la couche active 10. Cet amincissement est réalisé d'une façon uniquement partielle suivant la direction z de sorte que les zones amincies 11 formées à l'arrêt de l'oxydation présentent au moins une épaisseur e11 non nulle. L'oxydation de la couche active 10 se produit de préférence uniquement en dessous des espaces 30 inter-grilles. Les zones amincies 11 sont « auto-alignées » avec les espaces 30 inter-grilles. Les zones amincies 11 sont également homogènes entre elles. La consommation de matériau semi-conducteur de la couche active 10, autrement dit l'épaisseur des régions oxydées 17, est de l'ordre de 2nm à 6nm.

Lors de l'amincissement par oxydation, en fonction des matériaux des premières grilles 20, les flancs exposés des premières grilles 20 peuvent également être oxydés, formant ainsi des deuxièmes zones oxydées 21. Ces deuxièmes zones oxydées 21 n'altèrent pas le fonctionnement des premières grilles 20, et peuvent servir comme une couche d'isolation des flancs des premières grilles.

Comme illustré à la figure 1D, le procédé peut comprendre selon la première variante, le dépôt d'une couche d'espaceur 50 suite à la formation des zones amincies 11 par oxydation, sur les premières grilles 20 et dans les espaces 30 inter-grilles. Cette couche d'espaceur 50 couvre ainsi le sommet des premières grilles 20, les premières zones oxydées 17 ainsi que les deuxièmes zones oxydées 21. La couche d'espaceur 50 permet de protéger les flancs des premières grilles 20. La couche d'espaceur 50 permet également d'assurer une isolation électrique des premières grilles 20. La couche d'espaceur 50 peut être à base de nitrure de silicium SiN ou d'un matériau diélectrique à faible constante diélectrique, par exemple à base de SiCO.

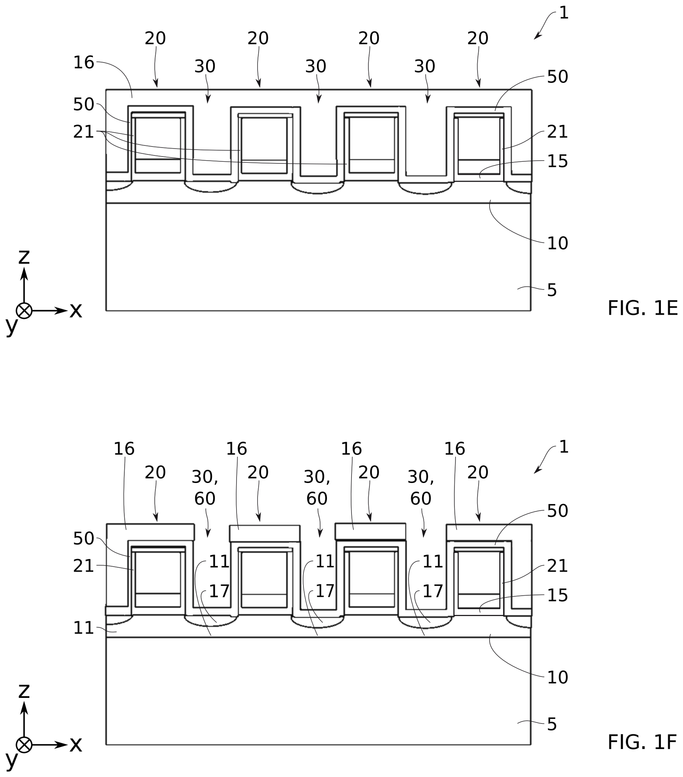

Comme illustré à la figure 1E, une deuxième couche diélectrique 16 est ensuite déposée sur la couche d'espaceur 50 de façon à couvrir les premières grilles 20 et à combler les espaces 30 inter-grilles. La deuxième couche diélectrique 16 peut être par exemple à base d'un oxyde, de préférence à base de SiO₂.

Comme illustré à la figure 1F, une étape classique de lithographie/gravure est réalisée sur la deuxième couche diélectrique 16, afin de définir des ouvertures 60 à travers la couche diélectrique 16 et les espaces 30 inter-grilles. Les ouvertures 60 s'étendent selon la direction z à l'aplomb des espaces 30 inter-grilles, jusqu'à la surface de la couche d'espaceur 50 au fond des espaces 30 inter-grilles.

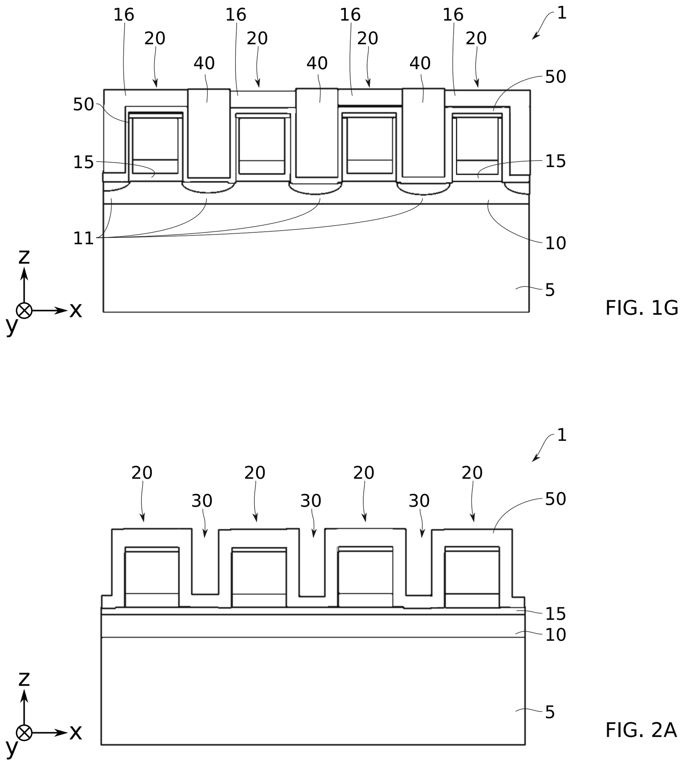

Comme illustré à la figure 1G, le procédé comprend en outre la formation d'un réseau de deuxièmes grilles 40. La formation des deuxièmes grilles 40 comprend un dépôt d'une couche métallique ou semi-conductrice fortement dopée sur la couche diélectrique 16 et dans les ouvertures 60. Cette couche de grille comble les ouvertures 60. Cette couche de grille peut être par exemple à base de silicium poycristallin. Cette couche de grille est ensuite planarisée, typiquement par polissage mécano-chimique CMP avec arrêt sur la deuxième couche diélectrique 16. Des deuxièmes grilles 40 sont ainsi formées dans les espaces 30 inter-grilles en alternance avec les premières grilles 20. Chaque deuxième grille 40 surmonte une zone amincie 11.

Un dispositif quantique 100 final est ainsi obtenu. Ce dispositif quantique 100 comprend des zones amincies 11 en dessous des espaces 30 inter-grilles. Ces zones amincies 11 présentent une continuité de matière avec la couche active 10. Ces zones amincies 11 présentent chacune au moins une épaisseur e11, telle que 0<e11<e10. De préférence, l'épaisseur e11 des zones amincies 11 est telle que e11 ≤ 0,8*e10. Le dispositif 100 comprend en outre deux réseaux de grilles. Les premières grilles 20, dites grilles de premier niveau, permettent de réaliser sous l'application d'un potentiel électrique, un confinement électrostatique des particules chargées présentes dans la couche active 10 sous-jacente, pour former une boîte quantique sous chaque première grille 20. Comme décrit précédemment, ce confinement électrostatique est avantageusement renforcé par le confinement structurel provenant des zones amincies 11. Cela permet de contrôler précisément le positionnement des boîtes quantiques dans la couche active 10.

En particulier, dans les zones amincies 11 où la couche active 10 est plus fine, la position des boîtes quantiques est moins favorable. A contrario, dans les parties de la couche active 10 plus épaisses sous les premières grilles 20, la position des boîtes quantiques est favorisée. Grâce à ce confinement structurel robuste, les irrégularités électrostatiques potentiellement présentes dans l'empilement de grille affectent moins la position des boîtes quantiques.

Les deuxièmes grilles 40, dites grilles de deuxième niveau, permettent de contrôler la barrière de potentiel, ou le couplage tunnel, entre deux boîtes quantiques voisines, sous l'application d'impulsions de tension. Le contrôle électrostatique exercé par les premières grilles 20, et le contrôle du couplage tunnel exercé par les deuxièmes grilles 40, sont réalisés indépendamment l'un de l'autre. Cela est assuré par l'isolation entre les deux niveaux de grilles à l'aide de l'espaceur 50 intercalé entre les premières et deuxièmes grilles 20, 40.

Les figures 2A à 2J illustrent schématiquement, les étapes du procédé de fabrication du dispositif quantique 100 selon une deuxième variante de l'invention.

Comme illustré à la figure 2A, suite à la formation des premières grilles 20, et avant l'amincissement de la couche active 10, selon la deuxième variante, une première couche d'espaceur 50 peut être déposée sur les premières grilles 20 et dans les espaces 30 inter-grilles. Cette première couche d'espaceur, permet de couvrir les flancs des premières grilles 20, assurant ainsi leur protection lors des étapes suivantes du procédé, notamment l'étape d'amincissement.

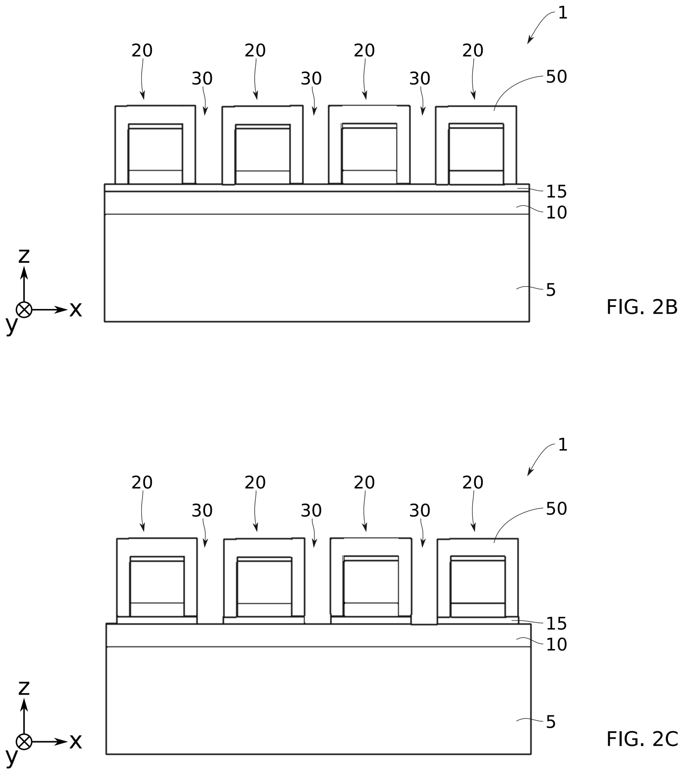

Comme illustré aux figures 2B et 2C, la première couche d'espaceur 50 est ensuite gravée dans les espaces 30 inter-grilles. La dimension latérale de la couche d'espaceur 50, selon x sur les coupes transverses illustrées par les figures, permet de contrôler la surface de la couche active 10 exposée. La couche diélectrique 15 est ensuite retirée sélectivement dans les espaces 30 inter-grilles, exposant ainsi la couche active 10 sous-jacente. Le retrait sélectif de la couche diélectrique 15, résulte en une exposition des flancs des parties restantes de la couche diélectrique 15.

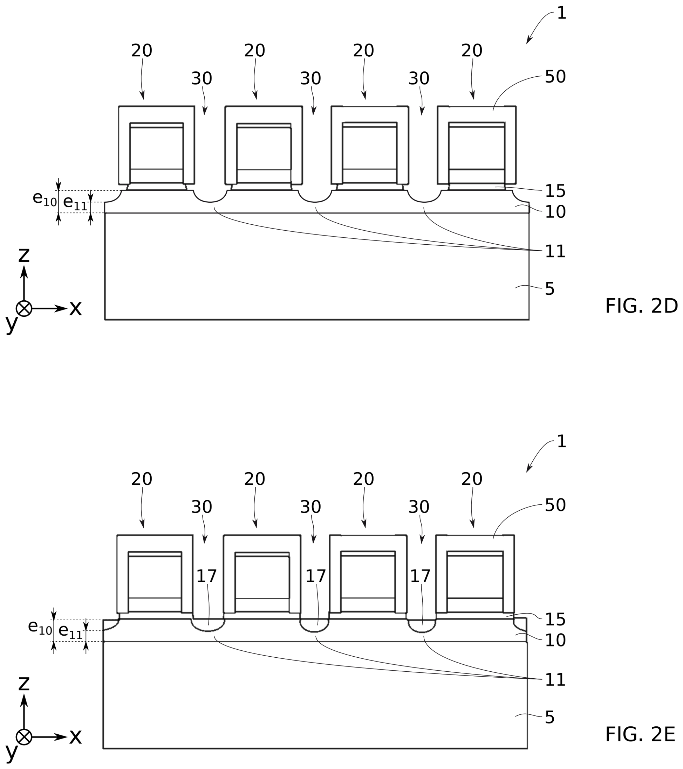

Comme illustré à la figure 2D, selon un exemple de réalisation, l'amincissement peut être réalisé par gravure uniquement partielle suivant la direction z de la couche active 10. Cet amincissement est donc réalisé par retrait de matière de la couche active 10 à l'aplomb des espaces 30 inter-grilles, formant ainsi des creux de matière dans la zone active 10, et délimitant des zones amincies 11. La gravure de la couche active 10 peut être réalisée par une gravure humide par exemple. Cette gravure peut également enlever une portion des flancs exposés de la couche diélectrique 15 restante.

Comme illustré à la figure 2E, selon un autre exemple de réalisation, l'amincissement de la couche active 10 peut être réalisé par oxydation comme décrit précédemment. Des zones oxydées 17 dans la couche active 10 sont ainsi formées, ces zones oxydées 17 délimitant des zones amincies 11 dans la couche active 10.

La couche d'espaceur 50 couvrant les flancs des premières grilles 20 permet notamment la protection de ces flancs contre l'oxydation, ou bien la gravure. Cette couche d'espaceur 50 permet également, en ajustant sa dimension latérale selon x sur les figures, de contrôler les dimensions latérales des zones oxydées 17 ou des creux formés suite à la gravure. La dimension latérale des zones amincies 11 est ainsi réduite. Un amincissement plus ponctuel de la couche active 10 peut être ainsi obtenu. Cela permet par exemple de renforcer le couplage tunnel entre deux boîtes quantiques voisines.

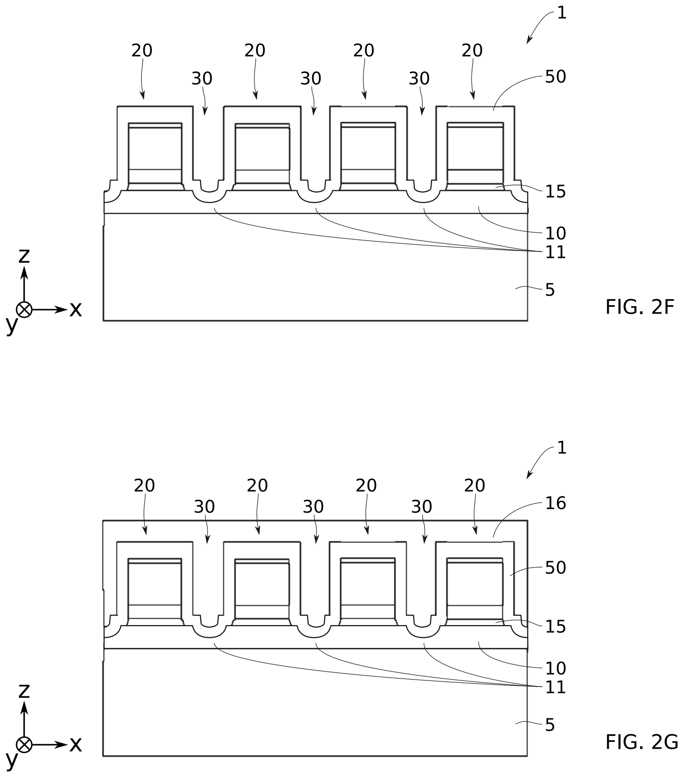

Par mesure de simplification, les figures 2F à 2I illustrent les étapes du procédé suivantes, suite à l'amincissement par gravure. L'homme du métier adapterait sans difficultés ces figures pour visualiser les étapes suivantes dans le cas d'un amincissement par oxydation.

Comme illustré à la figure 2F, suite à la formation des zones amincies 11, une deuxième couche d'espaceur 51 peut être déposée sur la première couche d'espaceur 50, et dans les espaces 30 inter-grilles. Cette deuxième couche d'espaceur 51 permet de couvrir les parties exposées des zones amincies 11, ainsi que les flancs exposés de la couche diélectrique 15 restante.

Comme illustré à la figure 2G, une deuxième couche diélectrique 16 est ensuite déposée sur l'espaceur 50, 51 de façon à couvrir les premières grilles 20 et à combler les espaces 30 inter-grilles.

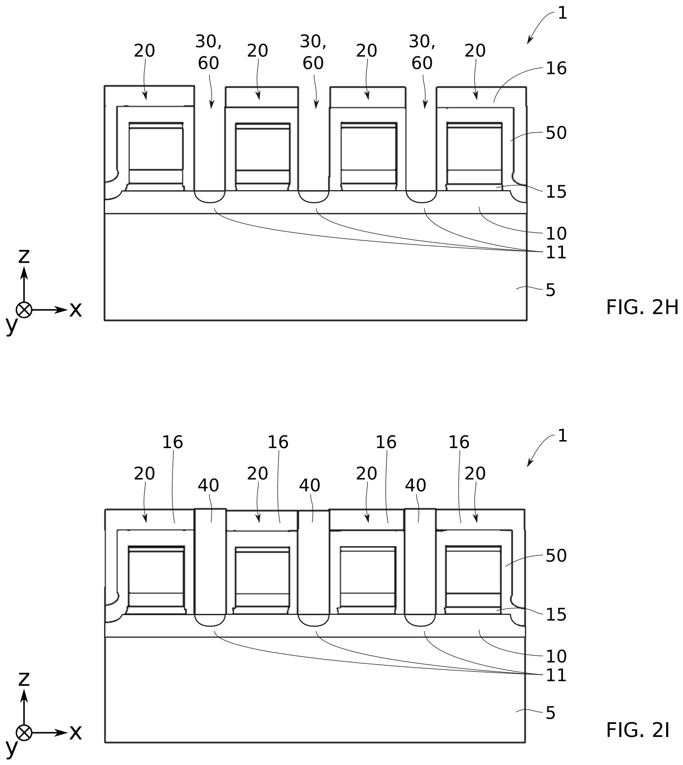

Comme illustré à la figure 2H, une étape classique de lithographie/gravure est réalisée sur la deuxième couche diélectrique 16, afin de définir des ouvertures 60 à travers la couche diélectrique 16 et les espaces 30 inter-grilles. Les ouvertures 60 s'étendent selon la direction z, à l'aplomb des espaces 30 inter-grilles, jusqu'à la surface de la couche d'espaceur 51 au fond des espaces 30 inter-grilles. De préférence, les ouvertures 60 s'arrêtent au sein des creux formés dans la couche active 10.

Comme illustré à la figure 2I, un réseau de deuxièmes grilles 40 est ensuite formé. La formation des deuxièmes grilles 40 comprend comme précédemment un dépôt d'une couche de grille sur la couche diélectrique 16 et dans les ouvertures 60. Cette couche de grille est ensuite planarisée, typiquement par polissage mécano-chimique CMP avec arrêt sur la deuxième couche diélectrique 16. Des deuxièmes grilles 40 sont ainsi formées dans les espaces 30 inter-grilles en alternance avec les premières grilles 20. Chaque deuxième grille 40 surmonte une zone amincie 11.

Un dispositif quantique 100 final est ainsi obtenu avec un amincissement par gravure, comme illustré à la figure 2I. Dans cet exemple, les deuxièmes grilles 40 peuvent être plus proches des zones amincies 11, étant uniquement séparées de celles-ci par la deuxième couche d'espaceur 51. De préférence, la deuxième couche d'espaceur 51 peut être directement au contact des zones amincies 11 et des deuxièmes grilles 40. Avantageusement, ces deuxièmes grilles 40 peuvent présenter chacune une extrémité inférieure située sous un plan passant par une face supérieure de la couche active 10. En d'autres termes, ces extrémités inférieures se situent au moins en partie dans les creux formés dans la couche active 10, suite à l'amincissement par gravure. Cette proximité entre les deuxièmes grilles 40 et les zones amincies 11 permet d'améliorer le contrôle du couplage tunnel entre deux boîtes quantiques voisines.

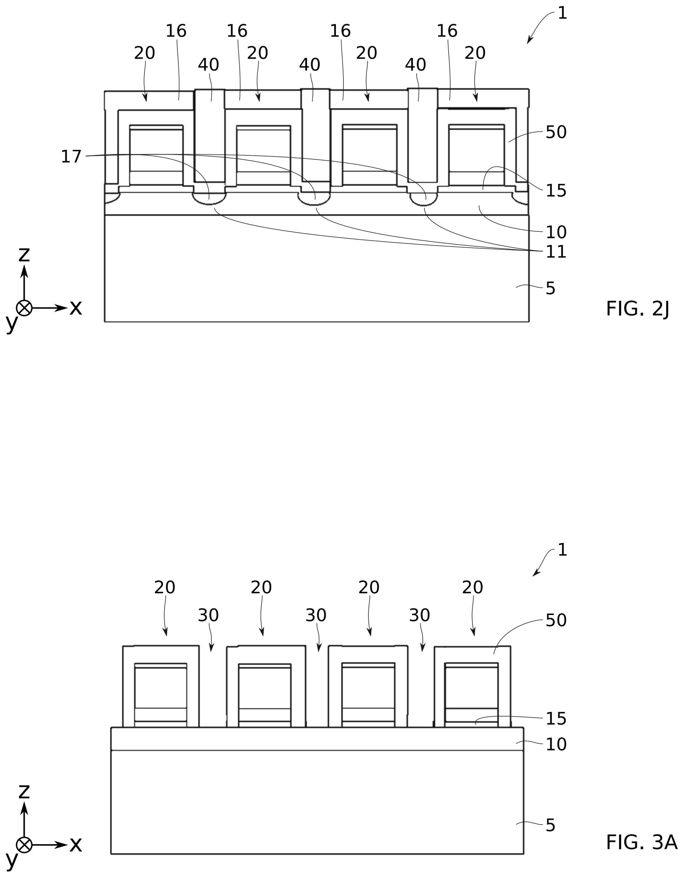

La figure 2J, illustre le dispositif quantique 100 final obtenu selon la deuxième variante et avec un amincissement par oxydation.

Les figures 3A à 3H, illustrent schématiquement, les étapes du procédé de fabrication du dispositif quantique 100 selon une deuxième variante de l'invention.

Comme illustré à la figure 3A, suite à la formation des premières grilles 20, et avant l'amincissement de la couche active 10, selon la troisième variante, la couche diélectrique 15 est retirée sélectivement dans les espaces 30 inter-grilles, exposant ainsi la couche active 10 sous-jacente, et des flancs des parties restantes de la couche diélectrique 15 situées à l'aplomb des premières grilles 20.

Suite au retrait de la couche diélectrique 15 dans les espaces 30 inter-grilles, une première couche d'espaceur 50 est déposée sur les premières grilles 20 et dans les espaces 30 inter-grilles. La première couche d'espaceur 50 est ensuite gravée dans les espaces 30 inter-grilles, exposant ainsi la couche active 10 dans les espaces 30 inter-grilles. Cette première couche d'espaceur 50, permet de couvrir les flancs des premières grilles 20, ainsi que les flancs des parties restantes de la couche diélectrique 15. Contrairement à la deuxième variante, où les flancs des parties restantes de la couche diélectrique 15 restent exposés lors de l'étape d'amincissement, dans cette troisième variante, la première couche d'espaceur 50 permet de protéger les flancs des premières grilles 20 ainsi que les flancs des parties restantes de la couche diélectrique 50 lors de l'amincissement, notamment par gravure. Cela évite le phénomène communément appelé « bec d'oiseau ». Le bec d'oiseau n'affecte pas le positionnement des boîtes quantiques, mais peut modifier ou perturber le couplage entre les premières grilles 20 et la couche active 10 sous-jacente. La première couche d'espaceur 50, selon la troisième variante, permet d'éviter la formation d'un bec d'oiseau, permettant ainsi d'améliorer le contrôle électrostatique via les premières grilles 20.

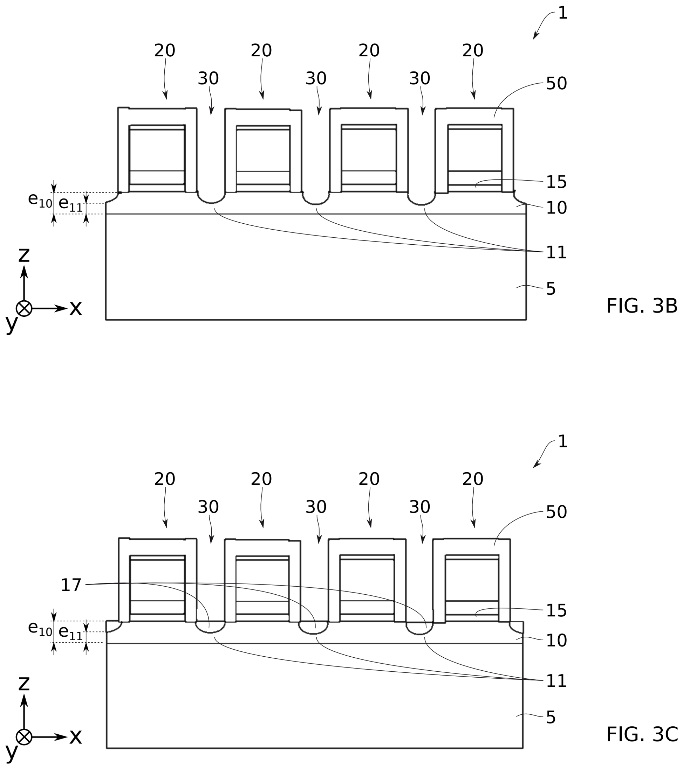

Comme illustré aux figures 3B et 3C, selon cette troisième variante, l'amincissement peut ensuite être mis en œuvre, respectivement, soit par une gravure uniquement partielle suivant la direction z de la couche active 10, soit par oxydation uniquement partielle de la couche active 10 suivant la direction z.

L'amincissement par gravure est réalisé par retrait de matière de la couche active 10 à l'aplomb des espaces 30 inter-grilles, formant ainsi des creux de matière dans la zone active 10, délimitant des zones amincies 11, comme illustré à la figure 3B.

L'amincissement par oxydation est réalisé en formant des zones oxydées 17 dans la couche active 10, délimitant des zones amincies 11 dans la couche active 10, comme illustré à la figure 3C.

Comme décrit précédemment, la première couche d'espaceur 50 permet de contrôler les dimensions latérales des zones oxydées 17 ou des creux formés suite à la gravure, et par conséquent, celles des zones amincies 11. Un amincissement localisé, presque « ponctuel », de la couche active 10 peut être ainsi obtenu.

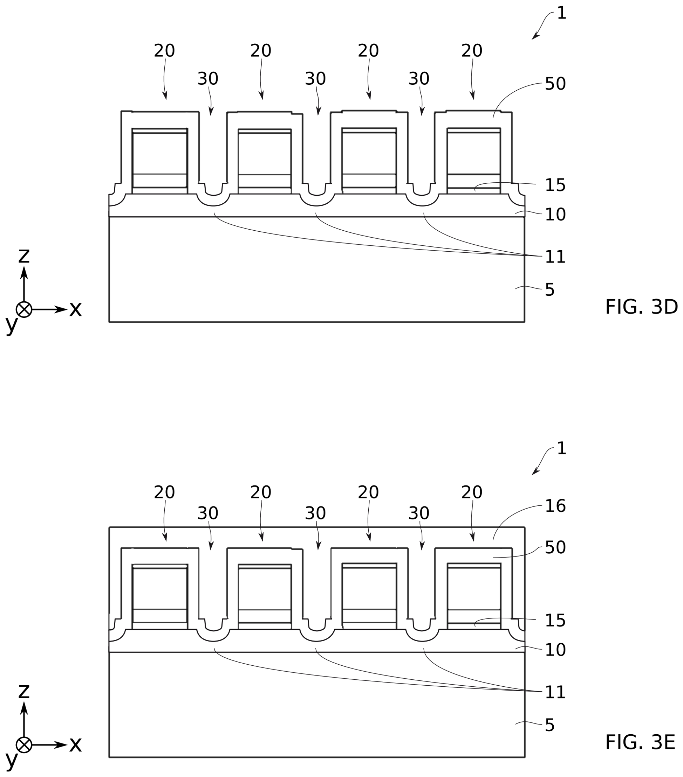

Par mesure de simplification, les figures 3D à 3G illustrent les étapes du procédé suivantes, suite à l'amincissement par gravure. L'homme du métier adapterait sans difficultés ces figures pour visualiser les étapes suivantes dans le cas d'un amincissement par oxydation.

Comme illustré à la figure 3D, suite à la formation des zones amincies 11, une deuxième couche d'espaceur 51 peut être déposée sur la première couche d'espaceur 50, et dans les espaces 30 inter-grilles. Cette deuxième couche d'espaceur 51 permet notamment de couvrir les parties exposées des zones amincies 11.

Comme illustré à la figure 3E, une deuxième couche diélectrique 16 est ensuite déposée sur l'espaceur 50, 51 de façon à couvrir les premières grilles 20 et à combler les espaces 30 inter-grilles.

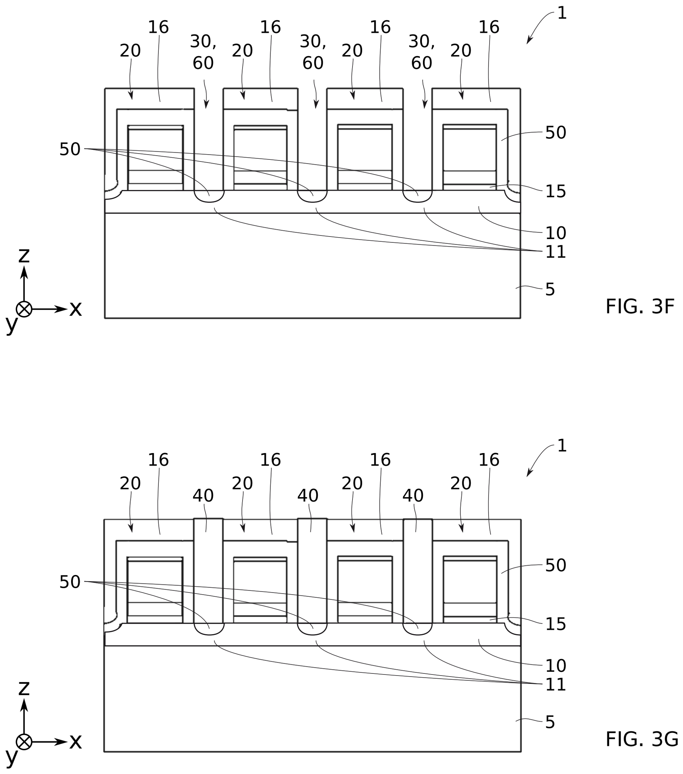

Comme illustré à la figure 3F, une étape classique de lithographie/gravure est ensuite réalisée sur la deuxième couche diélectrique 16, afin de définir des ouvertures 60 à travers la couche diélectrique 16 et les espaces 30 inter-grilles. Les ouvertures 60 s'étendent selon la direction z jusqu'à la surface de la couche d'espaceur 51 dans les espaces 30 inter-grilles. De préférence, les ouvertures 60 s'arrêtent au sein des creux formés dans la couche active 10.

Comme illustré à la figure 3G, un réseau de deuxièmes grilles 40 est ensuite formé. La formation des deuxièmes grilles 40 comprend comme précédemment un dépôt d'une couche de grille sur la couche diélectrique 16 et dans les ouvertures 60. La couche de grille est ensuite planarisée, typiquement par CMP avec arrêt sur la deuxième couche diélectrique 16. Des deuxièmes grilles 40 sont ainsi formées dans les espaces 30 inter-grilles en alternance avec les premières grilles 20. Chaque deuxième grille 40 surmonte une zone amincie 11.

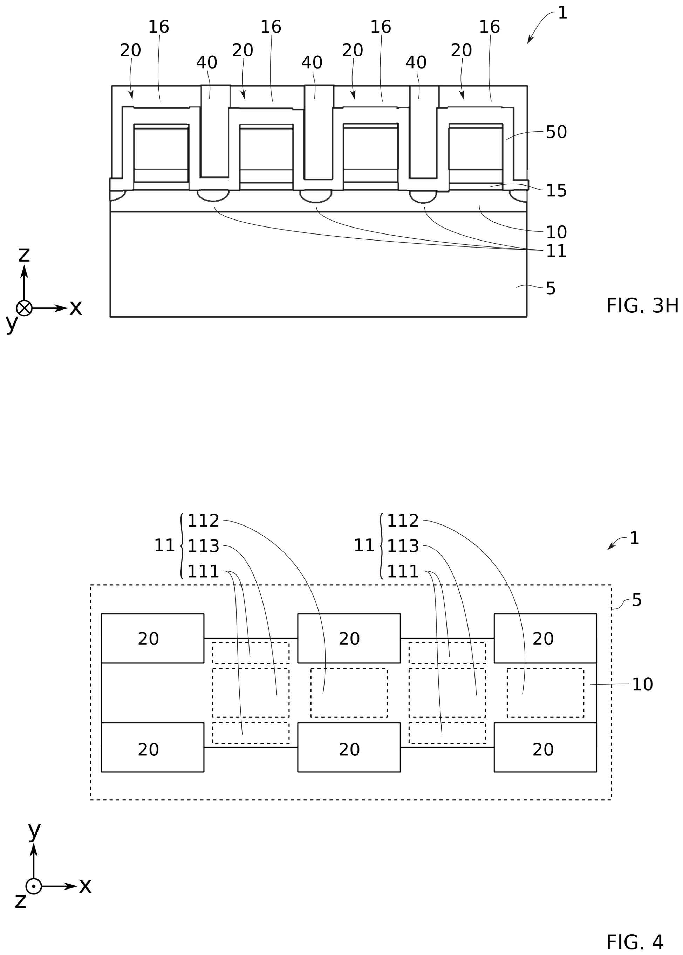

Comme pour la deuxième variante, un dispositif quantique 100 final est ainsi obtenu, soit par amincissement par gravure, comme illustré à la figure 3G, soit par amincissement par oxydation comme illustré à la figure 3H. Comme le montre la comparaison de ces deux exemples illustrés par les figures 3G et 3H, l'amincissement par gravure permet de rapprocher les deuxièmes grilles 40 des zones amincies 11. De préférence, la deuxième couche d'espaceur 51 peut être directement au contact des zones amincies 11 et des deuxièmes grilles 40. Avantageusement, ces deuxièmes grilles 40 peuvent présenter une extrémité inférieure située sous un plan passant par une face supérieure de la couche active 10.

Dans les variantes décrites ci-dessus, un dispositif quantique 100 comprenant une couche active 10 surmontée d'un réseau de premières grilles 20 juxtaposées selon la direction x, a été représenté. Ce dispositif 100 peut être par exemple un dispositif de type CMOS (« Complementary Metal-Oxide-Semiconductor », ou Semi-conducteur à oxyde de métal complémentaire), dans lequel la couche active 10 est un nanofil à base de silicium par exemple, s'étendant selon la direction x. Ce nanofil peut présenter une structure en mésa sur la couche de support S. Dans le cas d'une intégration de type mésa, l'oxydation peut agir également sur les dimensions latérales des structures mésa. Ce nanofil de silicium peut héberger des boîtes quantiques sous les premières grilles 20 agencées d'une façon unidimensionnelle (1D). D'autres types de dispositifs quantiques 100 peuvent également être envisagés, comme un dispositif de type CMOS bi-dimensionnel (2D) dans lequel la couche active 10 peut être surmontée d'un réseau de premières grilles 20 agencées selon les directions x et y, comme illustré à la figure 4.

La figure 4 illustre en vue de dessus un dispositif 100 CMOS 2D, dans le plan xy. Par mesure de simplification, la figure 4 n'illustre pas l'espaceur 50, ni la couche diélectrique 16, ni les deuxièmes grilles 40. Dans cet exemple de réalisation, des zones amincies 11 peuvent être réalisées selon l'une quelconque des variantes décrites précédemment. Ces zones amincies 11 peuvent être situées sous des premiers espaces 30 inter-grilles situés entres les premières grilles 20 selon la direction x, comme par exemple les zones 111. Selon un autre exemple, les zones amincies 11 peuvent être situées sous des deuxièmes espaces 30 inter-grilles situés entres les premières grilles 20 selon la direction y, comme par exemple les zones 112. Selon un autre exemple, les zones amincies 11 peuvent être situées sous des espaces 30 inter-grilles situés entres les premiers et deuxièmes espaces 30 inter-grilles, comme par exemple les zones 113.

Selon un exemple, les zones amincies 11, 111, 112, 113 peuvent présenter des épaisseurs différentes, que ce soit au sein d'un dispositif 1D ou d'un dispositif 2D. A titre d'exemple, les zones 111 de la figure 4 peuvent présenter une première épaisseur e111<e10, les zones 112 peuvent présenter une deuxième épaisseur e112<e10 et les zones 113 peuvent présenter une troisième épaisseur e113<10, telles que e111≠e112≠e113.

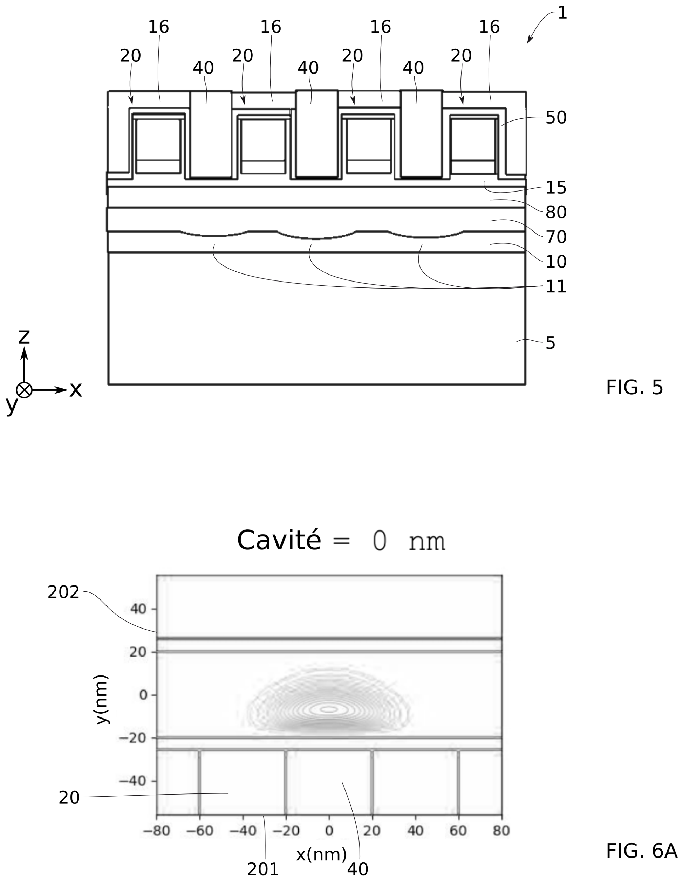

Comme illustré à la figure 5, le dispositif quantique 100 peut comprendre un substrat comprenant en empilement selon la direction z, une couche de support S, une couche active 10 comprenant des zones amincies 11, et une couche additionnelle 70 surmontant la couche active 10, de préférence à base du même matériau que celui de la couche de support S. Selon cet exemple, l'étape d'amincissement de la couche active 10 est réalisée avant l'étape de formation des premières grilles 20. La couche additionnelle 70 est formée ensuite sur la couche active 10 comprenant les zones amincies 11. L'empilement peut comprendre également d'autres couches, comme par exemple une troisième couche diélectrique 80 déposée sur la couche 70. Les premières grilles 20 peuvent ensuite être formées sur l'empilement, en respectant l'alignement des grilles 20 vis-à-vis des zones épaisses de la couche active 10. Selon une possibilité, le support S et la couche additionnelle 70 sont à base de SiGe et la couche active 10 est à base de Si. L'empilement des couches S/10/70 forme alors une hétérostructure du type SiGe/Si/SiGe. La zone d'accueil des qubits de spin se situe dans la couche active 10 à base de Si. Selon une possibilité alternative, le support S et la couche additionnelle 70 sont à base de SiGe et la couche active 10 est à base de Ge. L'empilement des couches S/10/70 forme dans ce cas une hétérostructure du type SiGe/Ge/SiGe. La zone d'accueil des qubits de spin se situe dans la couche active 10 à base de Ge.

Les figures 6A à 6C illustrent des résultats d'une simulation de la position de deux boîtes quantiques voisines du dispositif quantique de la présente invention, dans un plan xz pour différentes valeurs de l'épaisseur e11 des zones amincies. L'axe des abscisses 201 représente la distance selon la direction x et l'axe des ordonnées représente la distance selon la direction y. Dans cette simulation, la couche active 10 est à base de silicium, et présente une épaisseur e10=10 nm.

Comme décrit précédemment, le compromis entre le contrôle sur la position des QD par confinement structurel et le couplage tunnel des QD entre eux peut être optimisé en ajustant l'épaisseur e11 des zones amincies 11. En effet, en diminuant l'épaisseur e11 d'une zone amincie 11, le confinement structurel augmente et le couplage tunnel diminue. En augmentant l'épaisseur e11 d'une zone amincie 11, le confinement structurel diminue et le couplage tunnel augmente.

La figure 6A illustre un exemple dans lequel le retrait de matière (recess) est de 0 nm. Dans ce cas, l'épaisseur e11 est égale à l'épaisseur e10. Le confinement structurel est homogène dans toute la couche active 10. Le confinement structurel n'est pas plus important au niveau des espaces inter-grilles que sous les grilles. La simulation montre que les deux boîtes quantiques fusionnent sous l'application d'un potentiel électrique de l'ordre de 200 mV sur la deuxième grille surmontant la zone non amincie entre les boîtes quantiques.

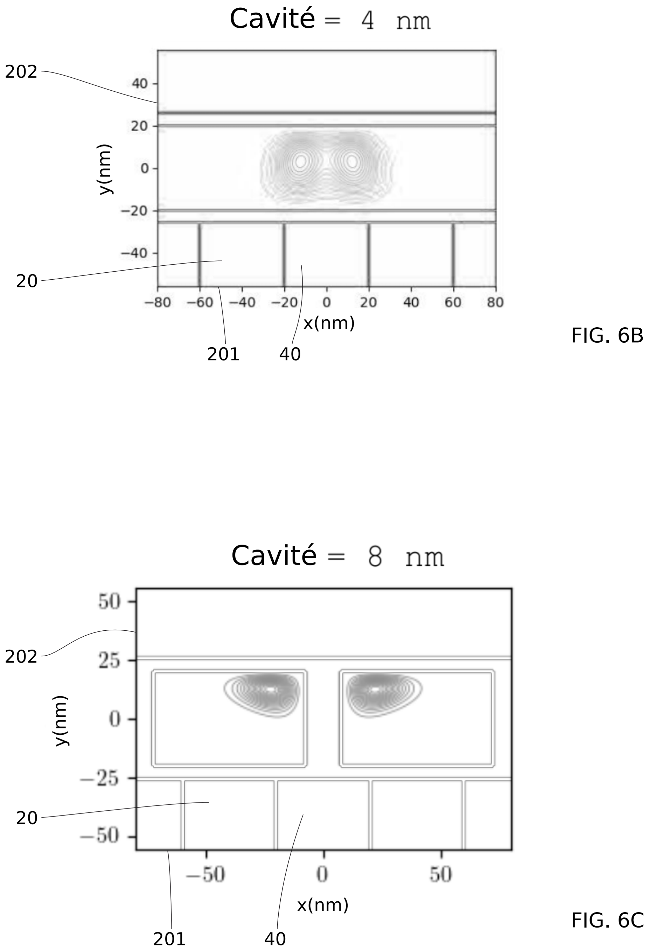

La figure 6B illustre un cas où le retrait de matière est de l'ordre de 4 nm (l'épaisseur e11 est de l'ordre de 6 nm). Dans ce cas, les boîtes quantiques ne fusionnent pas, même en appliquant des potentiels supérieurs à 400 mV. Le régime de couplage des boîtes quantiques reste exploitable pour des valeurs de potentiels au-delà de 800 mV, correspondant à un couplage tunnel supérieur à 10³ µeV.

La figure 6C illustre un cas où le retrait de matière est de l'ordre de 8 nm (l'épaisseur e11 est de l'ordre de 2 nm). Dans ce cas, le chevauchement entre les deux boîtes quantiques est limité, et le couplage tunnel maximal atteignable est réduit.

Par conséquent, pour une couche active 10 à base de silicium, ayant une épaisseur de l'ordre de 10 nm, l'épaisseur e11 optimale des zones amincies 11 est de l'ordre de 6 nm. Pour un retrait de matière supérieur à 8 nm, le couplage tunnel est considérablement réduit.

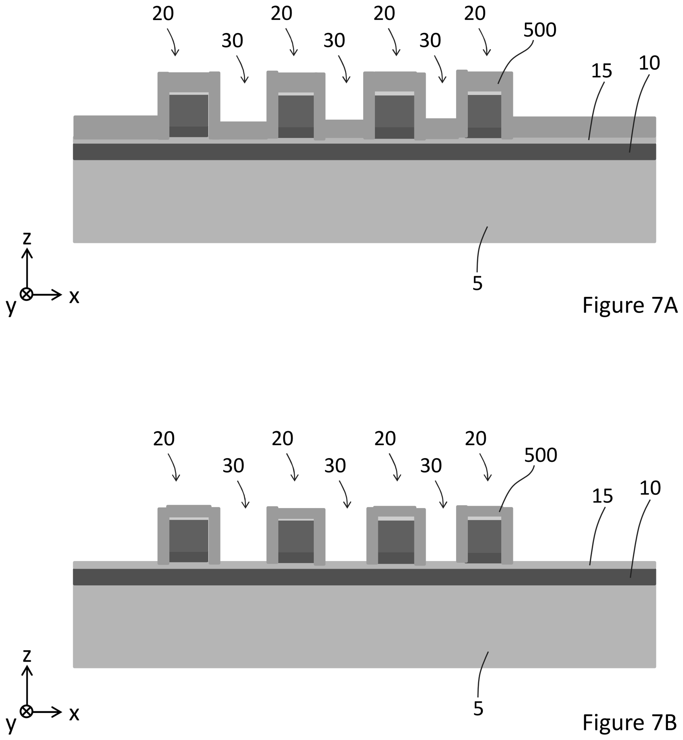

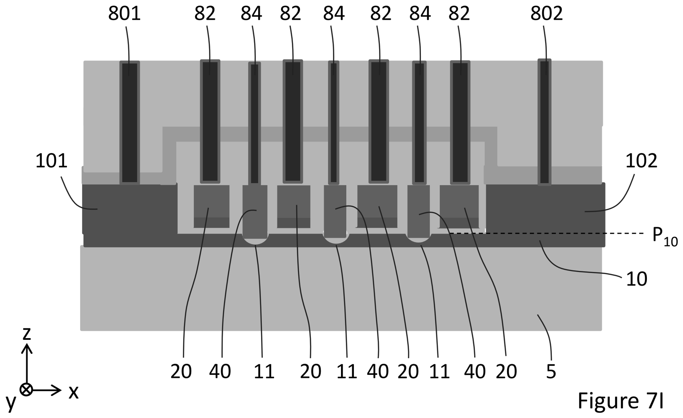

Les figures 7A à 7I illustrent schématiquement, les étapes du procédé de fabrication du dispositif quantique 100 selon une autre variante de l'invention.

Comme illustré à la figure 7A, suite à la formation des premières grilles 20, et avant l'amincissement de la couche active 10, une couche d'espaceur 500 peut être déposée sur les premières grilles 20 et dans les espaces 30 inter-grilles. Cette couche d'espaceur permet de couvrir les flancs des premières grilles 20, assurant ainsi leur protection lors des étapes suivantes du procédé, notamment l'étape d'amincissement. Le contrôle dimensionnel des premières grilles 20 est ainsi préservé. L'épaisseur de la couche d'espaceur 500 permet de moduler avantageusement la largeur des espaces 30, selon x. L'amincissement réalisé dans la suite est ainsi plus ou moins localisé ou étendu entre deux grilles 20. Un amincissement très localisé (couche d'espaceur 500 relativement épaisse) de la couche active 10 permet de maximiser le couplage tunnel entre boites quantiques.

Comme illustré à la figure 7B, la couche d'espaceur 500 est ensuite gravée dans les espaces 30 inter-grilles de façon à exposer la surface de la couche diélectrique 15. La couche diélectrique 15 est ensuite retirée sélectivement dans les espaces 30 inter-grilles, exposant ainsi la couche active 10 sous-jacente (non illustré).

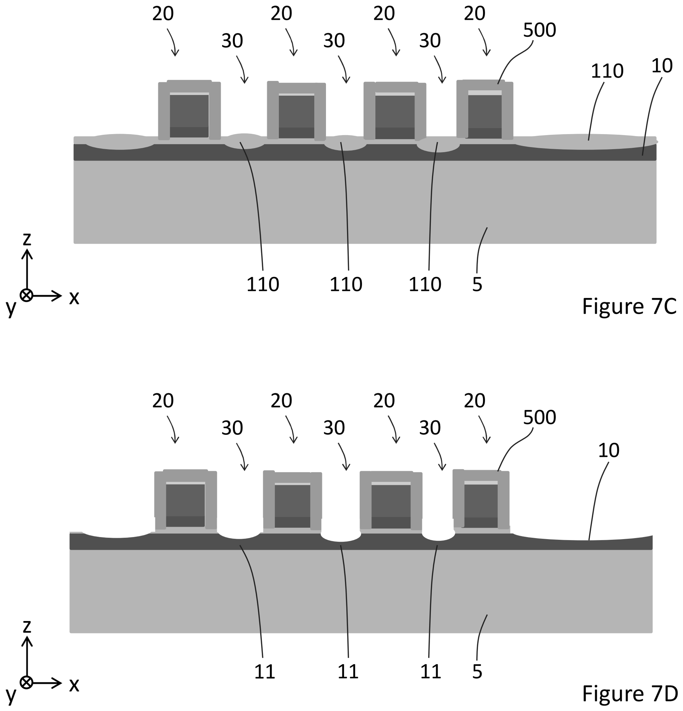

Comme illustré à la figure 7C, une oxydation de la couche active 10 peut ensuite être réalisée, au niveau des surfaces exposées de la couche active 10. Des portions oxydées 110 sont ainsi formées. Ces portions 110 s'étendent notamment dans la couche active 10, selon z.

Comme illustré à la figure 7D, une désoxydation est ensuite réalisée pour éliminer les portions oxydées 110. Il en résulte une couche active 10 présentant des zones amincies 11.

Alternativement, ces zones amincies 11 peuvent être obtenues par gravure directement après retrait sélectif de la couche diélectrique 15, comme décrit précédemment. La couche d'espaceur 500 permet à ce stade de limiter l'extension latérale des zones amincies 11, évitant avantageusement le phénomène connu sous le nom de « bec d'oiseau ».

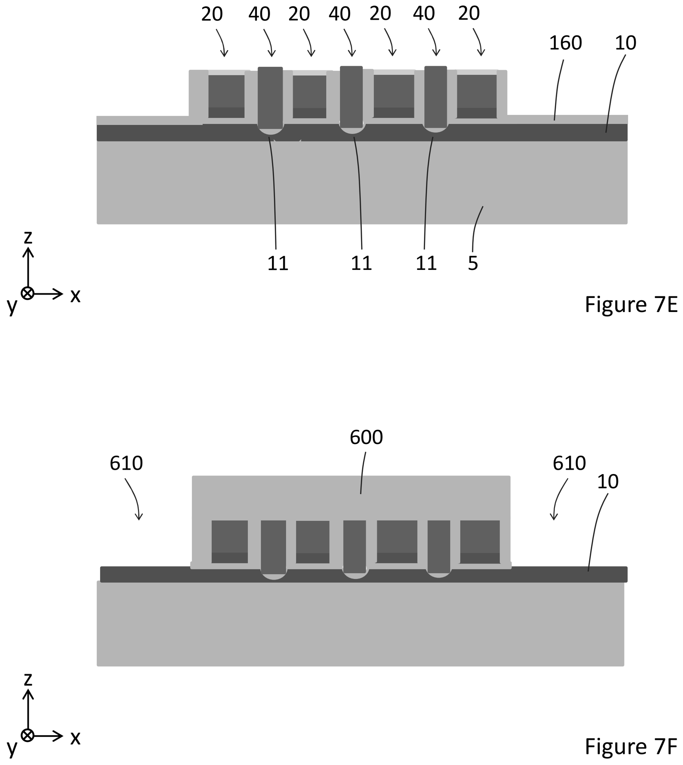

Comme illustré à la figure 7E, suite à la formation des zones amincies 11, la couche d'espaceur 500 est retirée, typiquement par gravure humide pour une couche 500 à base de SiN. Une deuxième couche diélectrique 160 est ensuite déposée ou formée sur la couche active 10 au niveau des zones amincies 11 au fond des espaces inter-grilles. Comme précédemment, un réseau de deuxièmes grilles 40 est ensuite formé. Les deuxièmes grilles 40 sont directement situées dans les espaces inter-grilles en alternance avec les premières grilles 20. Chaque deuxième grille 40 surmonte une zone amincie 11. Les premières et deuxièmes grilles 20, 40 peuvent être à base de métal.

Comme illustré à la figure 7F, les premières et deuxièmes grilles 20, 40 sont typiquement encapsulées par une couche d'oxyde 600. Des ouvertures 610 sont réalisées dans la couche d'encapsulation de part et d'autres du réseau de grilles 20, 40 de façon à exposer la couche active 10.

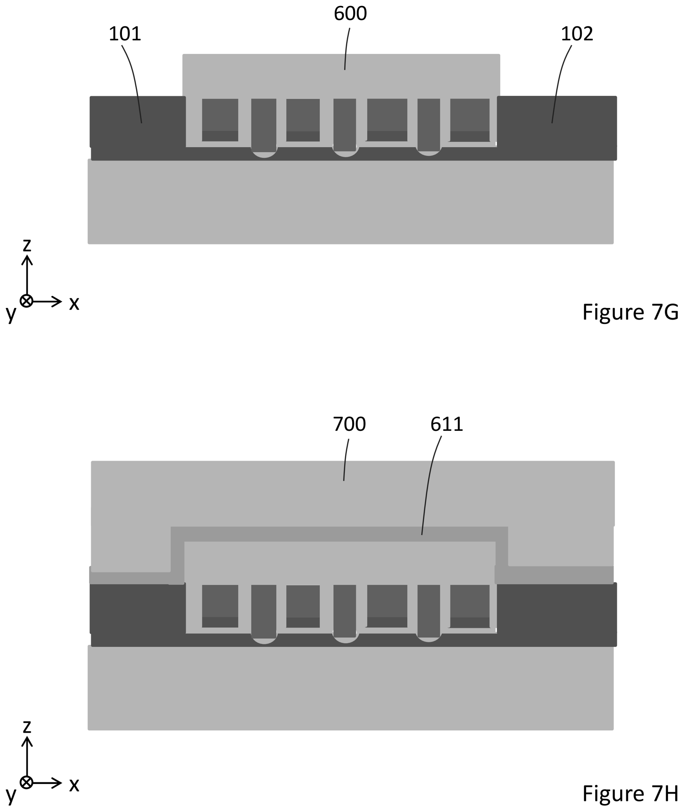

Comme illustré à la figure 7G, des réservoirs de charge 101, 102 sont réalisés par épitaxie sélective à partir de la couche active 10, au niveau des ouvertures 610. Ces réservoirs de charge 101, 102 sont typiquement à base de silicium dopé bore ou phosphore.

Comme illustré à la figure 7H, une étape de passivation comprenant typiquement le dépôt d'une couche diélectrique 611 à base de SiN est de préférence réalisée. Une nouvelle encapsulation par une couche d'oxyde 700, suivie d'une planarisation par CMP sont ensuite effectuées.

Comme illustré à la figure 7G, des contacts 801, 802, 82, 84 sont ensuite réalisés pour connecter respectivement les réservoirs 101, 102 et les grilles 20, 40 du dispositif quantique 100. Ces contacts peuvent se faire de façon classique en gravant des vias au travers des couches diélectriques 700, 611, 600 avant de les remplir de métal, par exemple Ti/TiN/W. Un recuit de siliciuration est typiquement effectué pour assurer un contact ohmique avec réservoirs 101, 102 et/ou les grilles 20, 40.

Dans l'exemple illustré, les deuxièmes grilles 40 s'étendent sous le plan P₁₀ correspondant à la surface initiale de la couche active 10, selon la direction z. Selon une autre possibilité, les extrémités inférieures des deuxièmes grilles 40 restent au-dessus de ce plan P₁₀.

L'invention n'est pas limitée aux modes de réalisations précédemment décrits.

## Revendications

1. Dispositif quantique (100) comprenant en empilement suivant une direction z :
• une couche de support (S),
• une couche active (10) à base d'un matériau semi-conducteur surmontant la couche de support (S) et présentant une épaisseur e10,
• une couche diélectrique (15) surmontant la couche active (10),
• un réseau de premières grilles (20) surmontant la couche diélectrique (15), les premières grilles (20) adjacentes du réseau étant séparées entre elles par des espaces (30) dits inter-grilles,
ledit dispositif (100) étant **caractérisé en ce que** la couche active (10) comprend, en dessous des espaces (30) inter-grilles, des zones amincies (11) à base du matériau semi-conducteur, lesdites zones amincies (11) présentant chacune au moins une épaisseur e11 > 0 telle que e11 < e10.

2. Dispositif quantique (100) selon la revendication précédente, dans lequel l'au moins une épaisseur e11 des zones amincies (11) est telle que e11 ≤ 0,8*e10.

3. Dispositif quantique (100) selon l'une quelconque des revendications précédentes, comprenant en outre un réseau de deuxièmes grilles (40) disposées dans les espaces (30) inter-grilles en alternance avec les premières grilles (20), de sorte que chaque deuxième grille (40) surmonte une zone amincie.

4. Dispositif quantique (100) selon la revendication précédente, dans lequel les deuxièmes grilles (40) présentent une extrémité située sous un plan passant par une face supérieure de la couche active (10).

5. Dispositif quantique (100) selon l'une quelconque des deux revendications précédentes, comprenant au moins une couche d'espaceur (50) couvrant des flancs des premières grilles (20), ladite au moins une couche d'espaceur (50) étant intercalée entre les deuxièmes grilles (40) et les zones amincies (11).

6. Dispositif quantique (100) selon l'une quelconque des revendications précédentes, dans lequel une première partie des zones amincies (11) présente une première épaisseur e111 < e10, et une deuxième partie des zones amincies (11) présente une deuxième épaisseur e112 < e10, la première épaisseur e111 étant différente de la deuxième épaisseur e112.

7. Dispositif quantique (100) selon la revendication précédente, dans lequel les zones amincies (11) de la première partie sont situées sous des espaces (30) inter-grilles situés entre des premières grilles (20) selon une première direction (x), et dans lequel les zones amincies (11) de la deuxième partie sont situées sous des espaces (30) inter-grilles situés entre des premières grilles (20) selon une deuxième direction (y).

8. Dispositif quantique (100) selon l'une quelconque des revendications précédentes, comprenant au moins une couche additionnelle (70) surmontant la couche active (10) et directement au contact de la couche active (10), ladite couche additionnelle (70) et le substrat (S) étant à base de SiGe et la couche active (10) étant à base de Si ou de Ge, de sorte que le substrat (S), la couche active (10) et la couche additionnelle (70) forment une hétérostructure de type SiGe/Si/SiGe ou SiGe/Ge/SiGe.

9. Dispositif quantique (100) selon l'une quelconque des revendications précédentes, dans lequel l'épaisseur e10 de la couche active (10) est de l'ordre de 10 nm et l'épaisseur e11 des zones amincies (11) est comprise entre 8 nm et 2 nm, de préférence de l'ordre de 6 nm.

10. Procédé de fabrication d'un dispositif quantique (1) selon l'une quelconque des revendications précédentes, ledit procédé comprenant :
• une fourniture d'une couche de support (S) et d'une couche active (10) à base d'un matériau semi-conducteur surmontant la couche de support (S), ladite couche active (10) présentant une épaisseur e10,
• une formation d'une couche diélectrique (15) surmontant la couche active (10),
• une formation, sur la couche diélectrique (15), d'un réseau de premières grilles (20), les premières grilles (20) adjacentes du réseau étant séparées entre elles par des espaces (30) dits inter-grilles,
le procédé étant **caractérisé en ce qu'**il comprend en outre :
• un amincissement uniquement partiel de la couche active (10), selon la direction z à l'aplomb des espaces (30) inter-grilles, de façon à former dans la couche active (10) les zones amincies (11).

11. Procédé selon la revendication précédente, dans lequel l'amincissement est réalisé, après retrait sélectif de la couche diélectrique (15) dans les espaces (30) inter-grilles, par une oxydation locale et uniquement partielle suivant la direction z de la couche active (10).

12. Procédé selon la revendication 10, dans lequel l'amincissement est réalisé, après retrait sélectif de la couche diélectrique (15) dans les espaces (30) inter-grilles, par une gravure uniquement partielle suivant la direction z de la couche active (10).

13. Procédé selon l'une quelconque des revendications 10 à 12, comprenant en outre, avant amincissement de la couche active (10), un dépôt d'une première couche d'espaceur (50) sur des flancs des premières grilles (20), de façon à protéger lesdits flancs lors de l'amincissement.

14. Procédé selon l'une quelconque des revendications 10 à 13, comprenant en outre, après amincissement de la couche active (10), un dépôt d'une deuxième couche d'espaceur (51) sur des flancs des premières grilles (20) et sur des parties exposées des zones amincies (11).

15. Procédé selon la revendication précédente, comprenant en outre, après dépôt de la deuxième couche d'espaceur (50), une formation d'un réseau de deuxièmes grilles (40) disposées dans les espaces (30) inter-grilles, en alternance avec les premières grilles (20).
